# EUROPÄISCHE PATENTSCHRIFT

(11) **EP 3 094 761 B1**
(45) Veröffentlichungstag und Bekanntmachung des Hinweises auf die Patenterteilung: **27.09.2017**
(21) Anmeldenummer: 15702642.8
(22) Anmeldetag: 14.01.2015
(51) Int. Cl.: C23C 16/40, C23C 16/513, H01J 37/32

(54) **PLASMABESCHICHTUNGSVERFAHREN ZUM ABSCHEIDEN EINER FUNKTIONSSCHICHT UND ABSCHEIDEVORRICHTUNG**
PLASMA COATING METHOD FOR DEPOSITING A FUNCTIONAL LAYER, AND DEPOSITING DEVICE
PROCÉDÉ DE REVÊTEMENT PAR PLASMA POUR DÉPOSER UNE COUCHE FONCTIONNELLE ET DISPOSITIF DE DÉPÔT

(30) Priorität: 15.01.2014 DE 102014100385
(43) Veröffentlichungstag der Anmeldung: 23.11.2016
(73) Patentinhaber: Plasma Innovations GmbH, 4800 Attnang-Puchheim (AT); Sura Instruments GmbH, 07745 Jena (DE)
(72) Erfinder: BISGES, Michael, 93049 Regensburg (DE); ECKARDT, Norbert, 07554 Gera (DE); TILLER, Christian, 07745 Jena (DE)
(74) Vertreter: Kohlmann, Kai
(86) Internationale Anmeldenummer: PCT/EP2015/050545
(87) Internationale Veröffentlichungsnummer: WO 2015/107059

(56) Entgegenhaltungen:
- EP-A1- 0 286 306
- WO-A1-2010/013293
- DE-A1-102006 038 780
- JP-A- 2013 010 234
- KR-A- 20090 112 831
- US-B1- 6 800 336

## Beschreibung

Die Erfindung betrifft ein Plasmabeschichtungsverfahren zum Abscheiden einer Funktionsschicht auf einer Oberfläche eines Substrats und eine Vorrichtung zur Durchführung des Beschichtungsverfahrens.

Aus dem Stand der Technik ist die Flammenbeschichtung zur Abscheidung funktioneller dünner Schichten, beispielsweise einer Silikatschicht, bei Atmosphärendruck bekannt. Das Verfahren gehört zur Gruppe der chemischen Gasphasenabscheidung. In den 1980er Jahren wurden erste Versuche zur Verbesserung der Haftfestigkeit von Metall-Kunststoff-Verbunden bei Dental-Keramiken durch im Wege der Flammenbeschichtung aufgebrachte Silikatschichten (SiO2) durchgeführt. In der Folgezeit wurde dieses Verfahren stetig weiter entwickelt und es wurden neue Anwendungsgebiete für im Wege der Flammenbeschichtung aufgebrachtes SiO2 gefunden. Dazu gehören neben der Verbesserung der Haftfestigkeit die breitbandige Reflexionsminderung von Flachglasoberflächen oder die Wirkung als Barriereschicht gegenüber verschiedenen Ionen. Bei der Flammenbeschichtung wird einem Brenngas ein zur Erzeugung der gewünschten Schicht geeignetes Beschichtungsmaterial (Präkursor) zugesetzt. Dies erfolgt in Gassteuerungsanlagen, die eine präzise Dosierung und optimale Durchmischung gewährleisten. Die Flamme wird in geringem Abstand über die Oberfläche des zu beschichtenden Substrats bewegt. Innerhalb der Flamme werden die Bestandteile des Beschichtungsmaterials thermisch aufgetrennt. Im inneren, reduzierenden Teil der Flamme werden organische Restgruppen des siliziumhaltigen Beschichtungsmaterials komplett aufgespalten. Freies Silizium liegt in diesem Bereich nun bindungsfähig vor. Im weiteren Verlauf dringen die aufgespaltenen und reduzierten Bestandteile in den von der Brennermündung weiter entfernten oxidierenden Bereich der Flamme vor. Innerhalb sehr kurzer Reaktionszeiten werden die freien Siliziumatome an den im oxidierenden Bereich der Flamme vorhandenen Sauerstoff gebunden. Dabei kommt es zu einer Bindung der Siliziumoxidbestandteile untereinander. Je länger dieser Prozess andauert, desto größer sind die in Erscheinung tretenden Silikatagglomerate. Beim Auftreffen auf die Oberfläche des Substrats tritt eine Vernetzung der Silikatagglomerate ein. Durch diese Vernetzung entsteht eine sehr feste, wenige Nanometer dicke, mit dem Substratmaterial unlösbar verbundene Silikatschicht. Die nanostrukturierte Silikatschicht vergrößert den Oberflächeninhalt des Substrates. Aufgrund der vergrößerten Oberfläche haften anschließend aufgetragener Klebstoff oder Lack besser. Außerdem werden für die Verbindung mit Klebstoffen und Lacken wichtige polare OH - Bindungen geschaffen.

Aus der DE 10 2006 024 050 A1 ist eine Vorrichtung zum Aufbringen einer gut haftenden korrosionsbeständigen Beschichtung auf eine Oberfläche eines Werkstücks mit einem Plasmaerzeuger zum Erzeugen eines Plasmas in einer Plasmakammer bekannt, durch die ein Prozessgas als Gasstrom geführt wird. Das Prozessgas ist ein Gemisch aus Argon und Wasserstoff. Das Plasma wird zwischen einer zylindrischen, spitz zulaufenden Kathode und einer koaxial zur Kathode liegenden Anode mit einer Spannungsquelle in der Plasmakammer erzeugt, wobei zwischen Kathode und Anode eine Spannung von 200 Volt besteht. In der Plasmakammer ist eine Zuführung für ein pulverförmiges Metallborid als Beschichtungsstoff angeordnet. Die Beschichtungsvorrichtung befindet sich in einer Vakuumkammer, die beim Beschichten auf einem Unterdruck von 50 mbar gehalten wird.

Das bekannte Niederdruckverfahren stellt hohe apparative Anforderungen, da eine Vakuumkammer benötigt wird. Nachteilig sind außerdem die geringe Abscheidungsrate und das beschränkte Fassungsvermögen der Vakuumkammer, das die Größe der zu beschichtenden Substrate begrenzt.

Um die Nachteile einer Vakuumkammer zu vermeiden, wurden Atmosphärendruck-Plasmabeschichtungsverfahren vorgeschlagen: Aus der DE 10 2009 048 397 A1 ist beispielsweise ein Plasmabeschichtungsverfahren zum Abscheiden einer Funktionsschicht mit fein dispergierten Nanopartikeln auf einer Oberfläche eines Substrats bekannt, das die folgenden Schritte umfasst:
- Bereitstellen von Sauerstoff oder Stickstoff als Träger- bzw. Prozessgas für das Plasmabeschichtungsverfahren,
- Erzeugen eines Plasmastrahls unter Atmosphärendruck durch Anregen des durch eine Düse mit einem Düsenkopf strömenden Sauerstoffs zwischen zwei im Abstand zwischen 5 und 100 mm liegenden Elektroden mittels einer Hochspannung,
- Einbringen eines Beschichtungsmaterials in gasförmigem, flüssigem oder festem Zustand in den Plasmastrahl und
- Ausrichten des aus dem Düsenkopf austretenden Atmosphärendruckplasmas auf die Oberfläche des Substrats, das relativ zur Plasmadüse bewegt wird.

Außerdem ist ein Kaltplasmabeschichtungsverfahren für Funktionsschichten, wie beispielsweise eine Korrosionsschutzbeschichtung oder eine Antihaftbeschichtung, der Firma Plasmatreat GmbH aus D-33803 Steinhagen bekannt geworden, bei dem dem Plasma über einen speziellen Düsenkopf je nach Anwendung spezifische Zusatzstoffe zugeführt werden.

Diese werden durch das Plasma angeregt und ihre Reaktivität dabei erhöht. So können sich die Zusatzstoffe während der Plasmabeschichtung an der Materialoberfläche besser anlagern und fest anbinden. Technisch wird der bei Raumtemperatur flüssige Zusatzstoff verdampft, der reproduzierbar mittels Luft oder Stickstoff als Trägergas in das Plasma eingeleitet wird. Das Kaltplasmabeschichtungsverfahren zeichnet sich durch einen großen Elektrodenabstand und folglich eine lange Entladungsstrecke sowie geringe Temperaturen (<500°C) in unmittelbarer Nähe der Bogenentladung aus. Für die Erzeugung der Bogenentladung sind hohe Spannungen zwischen den Elektroden erforderlich. (Nachteilig ist, dass die bekannten Plasmabeschichtungsverfahren eine direkte Oxidation des Beschichtungsmaterials innerhalb des Plasmastrahls nutzten.

Die Verfahren führen zu niedrigen Beschichtungsgeschwindigkeiten und zu sehr niedrigen Abscheideraten auf dem Substrat. Insbesondere das Kaltplasmabeschichtungsverfahren erreicht in der Praxis nur geringe Beschichtungsgeschwindigkeiten. Die eingangs erwähnte Flammbeschichtung ist besonders bei thermisch empfindlichen Substraten oder in explosionsgeschützter Umgebung, die in vielen Bereichen der Oberflächenveredelung vorliegt, wie beispielsweise Lösemittel in Klebstoffen und Druckfarben, nur begrenzt einsetzbar. Das Kaltplasma muss in einem geringen Abstand zum Substrat (5-10 mm) über die Fläche geführt werden und kann verfahrensbedingt nur sehr schmale Bereiche der Oberfläche abdecken. Typische Verfahrgeschwindigkeiten liegen im Bereich von 10 mm/sec - 50 mm/sec. Industriell benötigt werden deutlich höhere Geschwindigkeiten von 100 - 1000 mm/sec.

Ferner ist aus der WO 2010/013293 A1 ein Verfahren zur Herstellung kristalliner Oberflächen bekannt geworden, bei dem ein Substrat, auf einem Halter in einer Vakuumkammer angeordnet wird. Auf dem Substrat wird vor dem Einbringen in die Vakuumkammer amorphes Silizium abgeschieden. In der Vakuumkammer ist eine Düse mit einer Austrittsöffnung angeordnet, die eine stabförmigen Kathode und eine die Kathode umgebenden Anode umfasst. In den Ringraum zwischen Kathode und Anode wird Argon eingeleitet. In der Vakuumkammer wird durch Anregen des durch die Düse strömenden Argons ein Plasmastrahl erzeugt, wobei die Anregung des Argons durch eine Bogenentladung zwischen der Anode und der Kathode erfolgt, die mit einer Gleichstromversorgung verbunden sind und der Strom zur Erzeugung der Bogenentladung 150 A und die Spannung zur Erzeugung der Entladung 13 - 14 V beträgt. In die Austrittsöffnung wird bevor der Plasmastrahl die Düse verlässt, Sauerstoff und Stickstoff eingeblasen. Die Austrittsöffnung der Düse ist auf die mit amorphem Silizium beschichte Oberfläche des Substrats ausgerichtet. Der auf die Oberfläche auftreffende thermische Plasmastrahl erzeugt aus der amorphen Oberfläche eine kristalline Oberfläche, wobei das Substrat mittels einer Bewegungsvorrichtung relativ zu dem Plasmastrahl bewegt wird.

Die Patentschrift JP2013010234 A offenbart ein Verfahren und eine Vorrichtung zur Plasmabeschichtung mittels einer Plasmadüse bei Atmosphärendruck. Ausgehend von diesem Stand der Technik liegt der Erfindung die Aufgabe zu Grunde, ein Plasmabeschichtungsverfahren zum Abscheiden einer Funktionsschicht, insbesondere einer Silikatschicht, anzugeben, das hohe Beschichtungsgeschwindigkeiten und Abscheideraten ermöglicht und unter normalen atmosphärischen Bedingungen abläuft. Außerdem soll eine Vorrichtung zur Durchführung des Verfahrens angegeben werden.

Diese Aufgabe wird durch ein Verfahren mit den Merkmalen des Anspruchs 1 und eine Vorrichtung mit den Merkmalen des Anspruchs 15 gelöst.

Die Lösung beruht auf dem Gedanken, ein atmosphärisches Plasma, und ein Inertgas als Trägergas zu verwenden, wobei eine Anregung des Inertgases durch einen Lichtbogenentladung mit einem hohem Strom von über 10 A, vorzugsweise über 50 A, und einer geringen Spannung von höchstens 100 V, vorzugsweise höchstens 50V, erfolgt. Die Begrenzung der Spannung auf 50 V verhindert ein vollständiges Aufbrechen der Molekülketten des Beschichtungsmaterials selbst bei sehr kleinen Elektrodenabständen von weniger als 5 mm. Hierdurch können einerseits sehr hohe Energien zum Starten einer chemischen Reaktion in das Beschichtungsmaterial (Precursor) eingebracht werden, andererseits wird eine kontrollierbare chemische Reaktion unter Ausschluss von Luftsauerstoff im Plasma bis zu dessen Austritt aus dem Plasmakopf ermöglicht.

Der hohe Strom und die relativ niedrige Spannung ermöglichen geringere Elektrodenabstände als bei den im Stand der Technik üblichen hohen Spannungen bei Atmosphärendruck-Plasmen; daraus folgt eine höhere Plasmaenergiedichte mit höheren Temperaturen. Bei hohen Spannungen, wie im Stand der Technik üblich, sind relativ große Elektrodenabstände erforderlich, um eine ausreichende Plasmaenergiedichte bereitzustellen. Um ein Durchschlagen des Lichtbogens bereits bei zu niedrigen Spannungen zu vermeiden, werden im Stand der Technik vorzugsweise Luft oder Stickstoff als Prozessgase, d.h. schwierig ionisierbare Gase, verwendet. Würde indes Argon als Prozessgas verwendet, müsste der Abstand der Elektroden nochmals vergrößert und/oder die Elektroden müssten durch einen Isolator gegeneinander abgeschirmt werden (DBD), um ein Durchschlagen des Lichtbogens bei zu niedriger Spannung zu vermeiden. Ein derartiger Isolator zwischen den Elektroden ist bei dem erfindungsgemäßen Verfahren und der Vorrichtung indes nicht erforderlich und vorgesehen.

Bei der Erfindung lässt sich jedoch selbst bei einem Elektrodenabstand von weniger als 5 mm zwischen den Elektroden eine ausreichende Energie zur Anregung des Inertgases einbringen und dadurch auf kleinstem Raum sehr hohe Energiedichten und Temperaturen in dem Plasma erzeugen. Hierdurch lässt sich wirksam die erforderliche hohe Energie zum Starten der kontrollierten Reaktion in das Beschichtungsmaterial einbringen.

Das als Trägergas verwendete Inertgas ist reaktionsträge und ermöglicht die kontrollierbare chemische Reaktion unter Ausschluss von Luftsauerstoff, ohne auf die Vorteile des Atmosphärendruckplasmas verzichten zu müssen. Atmosphärendruckplasma bezeichnet ein Plasma, bei welchem der Druck ungefähr dem der umgebenden Atmosphäre - dem sogenannten Normaldruck - entspricht. Im Gegensatz zum Niederdruckplasma oder Hochdruckplasma wird kein Reaktionsgefäß benötigt, das für die Aufrechterhaltung eines zum Atmosphärendruck unterschiedlichen Druckniveaus sorgt. Der Ausschluss von Luftsauerstoff verhindert eine direkte Oxidation des Beschichtungsmaterials innerhalb des Plasmastrahls, wodurch die hohen Energien zum Starten der chemischen Reaktion in das Beschichtungsmaterial eingebracht werden können. Folglich eignet sich das erfindungsgemäße Verfahren insbesondere für kontinuierliche, industrielle Beschichtungsverfahren mit hohen Beschichtungsgeschwindigkeiten.

In vorteilhafter Ausgestaltung der Erfindung kommt ein Edelgas, insbesondere Argon als inertes Trägergas zum Einsatz, das eine Reinheit von mindestens 4.6, vorzugsweise jedoch 4.8 oder 5.0 aufweist. Die Reinheit bezeichnet den Stoffmengenanteil des Argons zum gesamten Stoffgemisch. Die unerwünschten Stoffe sind Verunreinigungen. Die Reinheit wird vorstehend mit Hilfe von Codewerten ausgedrückt. Dabei bezeichnet die erste Ziffer die Anzahl der "Neuner", die zweite Ziffer ist die erste von "Neun" abweichende Dezimalstelle. Argon 4.6 bezeichnet z.B. ein Argon mit 99,996 Vol.-% Argon.

Die Anregung des Inertgases erfolgt durch eine Lichtbogenentladung zwischen zwei im Abstand zueinander angeordneten Elektroden, die mit einer Stromquelle verbunden sind. Die Anregung kann im Wege der AC- (Wechselstrom-) Anregung durch niederfrequente Wechselströme, durch Anregung mit Wechselströmen im Radiowellen-Bereich und durch Mikrowellenanregung erfolgen. Bevorzugt erfolgt die Anregung jedoch im Wege der DC- (Gleichstrom-) Anregung. Es wurde festgestellt, dass Argon einen Betrieb mit einer äußerst geringen Spannung zur Erzeugung der Lichtbogenentladung ermöglicht.

Der Abstand zwischen den Elektroden, der Strom und die Spannung zur Erzeugung der Lichtbogenentladung und der der Düse zugeführte Inertgasstrom werden vorzugsweise derart bestimmt, dass die Plasmatemperatur im Lichtbogen 10.000°C-50.000°C und/oder die Plasmatemperatur 50 mm in Austrittsrichtung des Plasmastrahls hinter dem Düsenkopf weniger als 500°C beträgt, so dass die Oberfläche des Substrats thermisch nur gering belastet wird. Der Abstand des Düsenkopfs zur Oberfläche wird insbesondere bei temperaturempfindlichen Substraten so gewählt, dass an der Oberfläche die Plasmatemperatur kleiner als 300° C ist.

Das Beschichtungsmaterial wird gasförmig, insbesondere dampfförmig in den Plasmastrahl in einem Zuführbereich eingebracht, wobei der Zuführbereich in einem Bereich des Plasmastrahls mit einer Temperatur angeordnet ist, die ein teilweises thermisches Aufbrechen der molekularen Bindungen des Beschichtungsmaterials bewirkt. Durch das Aufbrechen suchen die freien Radikale neue Bindungen zur den Molekülen der Substratoberfläche und den übrigen teilweise aufgebrochen Molekülen.

Der Zuführbereich des Plasmastrahls befindet sich innerhalb der Düse vorzugsweise in dem Bereich des Lichtbogens zwischen den beiden Elektroden, wo die Plasmatemperatur 10.000°C - 50.000°C beträgt. Der Begriff "dampfförmig" im Zusammenhang mit dem Beschichtungsmaterial ist dahingehend zu verstehen, dass das Beschichtungsmaterial als chemisch reiner, gasförmiger Stoff in Bezug zu seinem flüssigen oder festen Aggregatzustand vorliegt.

Durch Einstellen des Abstandes zwischen dem Düsenkopf und der zu beschichtenden Oberfläche eines Substrats wird die chemische Reaktion durch den in den Randbereichen des Plasmastrahls vorliegenden Luftsauerstoff und der Umgebungsatmosphäre eingestellt. Das Trägergas vermischt sich in den Randbereichen durch Verwirbelung mit dem Luftsauerstoff. Durch den Ausschluss von Luftsauerstoff werden darüber hinaus Verschmutzungen des Düsenkopfes durch sekundäre Abscheidungen oxydischer Partikel vermieden.

Als Beschichtungsmaterialien eignen sich insbesondere metallorganische Verbindungen, wie z.B. Silane, Siloxane und diverse Metallalkoholate wie Titantetraisopropylat, seltener werden auch Salze wie Metallacetate und Metallnitrate oder Nanopartikel als Beschichtungsmaterial in den Plasmastrahl eingebracht. Es können auch Mischungen mehrerer metallorganischer Verbindungen als Beschichtungsmaterialien zum Einsatz gelangen.

Die einzeln oder in Kombination verwendbaren Beschichtungsmaterialen stammen vorzugsweise aus der nachfolgenden Gruppe:
SiO₂, WOₓ, MoOₓ, ZnO, ZrO₂, SnO₂, TiO₂, Ag, Al₂O₃.

Mit SiO₂ werden Silikatschichten erzeugt. Frisch erzeugte Silikatschichten sind sehr reaktionsfreudig und eignen sich daher gut als haftvermittelnde Schichten für Lacke und Verklebungen. Des weiteren lassen sich mit Silikatschichten optische Eigenschaften verbessern (z. B. Transmissionserhöhung) oder ein Barriereschutz erzeugen, z. B. gegen Gase wie O₂ und bewegliche Ionen wie Na⁺.

Mit WOₓ, MoOₓ als chromogene Materialien lassen sich Schichten zur Erzeugung sogenannter "Intelligenter Verglasungen" erzeugen.

ZnO als Beschichtungsmaterial ist Bestandteil transparenter, elektrisch leitfähiger Oxide wie Aluminium-Zinkoxid (AZO).

Mit ZrO₂ als Beschichtungsmaterial lassen sich Schutzschichten gegen mechanische Einflüsse erzeugen, beispielsweise ein Kratzschutz.

SnO₂ als Beschichtungsmaterial ist Bestandteil verschiedener transparenter, elektrisch leitfähiger Oxide, wie z. B. Indiumzinnoxid (ITO), Fluorzinnoxid (FTO) und Antimonzinnoxid (ATO).

Mit TiO₂ als Beschichtungsmaterial lassen sich photokatalytische Schichten auf einem Substrat abscheiden.

Mit Ag als Beschichtungsmaterial lassen sich Schichten mit hoher elektrischer Leitfähigkeit, Wärmeschutzverglasungen und antibakterielle Beschichtungen erzeugen.

Mit Al₂O₃ als Beschichtungsmaterial lassen sich Schichten zum Schutz vor Glaskorrosion herstellen.

In vorteilhafter Ausgestaltung der Erfindung wird das Beschichtungsverfahren zweistufig ausgeführt. Nach dem Abscheiden einer als Silikatschicht ausgebildeten Funktionsschicht erfolgt eine Silanisierung der Oberfläche. Wie bereits erwähnt, eignen sich frisch erzeugte Silikatschichten gut als haftvermittelnde Schichten für Lacke und Verklebungen. Durch das zusätzliche Silanisieren, beispielsweise durch das Abscheiden von Silan-basierten Haftvermittlern, wie Glymo, kann die Haftung zusätzlich verbessert werden. Die Silanverbindungen werden vorzugsweise mittels eines Druckkopfes auf die Silikatschicht aufgebracht.

Ein Anwendungsbeispiel für das zweistufige Beschichtungsverfahren ist die Erzeugung einer Haftvermittlungsschicht auf Glasoberflächen für einen nachfolgenden Digitaldruck:
Im Zusammenhang mit Plasmabeschichtungsverfahren bestand bisher keine Möglichkeit für die Erzeugung von haftfesten Schichten auf Glasoberflächen mit UV-Härtenden Farben im Digitaldruckverfahren. Mit dem erfindungsgemäßen Verfahren wird zunächst eine vollflächige Silikatschicht auf der Glasoberfläche erzeugt. Danach wird eine Silanisierung entweder durch aufsprühen oder durch direkten Auftrag über eine Digital-Druckkopf erzeugt. Die Silanisierung bietet einen optimalen Haftgrund für eine UV-härtbare Digitaldruck-Tinte. Das Bedrucken von Glasoberflächen lässt sich vorteilhaft für einen Dekordruck auf Glas, beispielsweise für das Bedrucken von Parfümflakons, einsetzen.

Alternativ besteht die Möglichkeit, in einem zweistufigen Plasmabeschichtungsverfahren auf die abgeschiedene Silikatschicht mit dem erfindungsgemäßen Plasmabeschichtungsverfahren eine metallische oder metalloxidische Schicht abzuscheiden, um einen optimalen Haftgrund für beispielsweise UV-Härtende Farben zu schaffen.

Weitere Vorteile und Wirkungen der Erfindung sowie der Aufbau einer Vorrichtung zur Durchführung des Verfahrens werden nachfolgend anhand der Ausführungsbeispiele näher erläutert.

Es zeigen:
- **Figur 1**: eine schematische geschnittene Darstellung einer Vorrichtung zur Durchführung des erfindungsgemäßen Plasmabeschichtungsverfahrens sowie
- **Figur 2**: eine schematische Darstellung einer Anordnung zur Durchführung eines zweistufigen Beschichtungsverfahrens für die Erzeugung von Haftvermittlungsschichten auf Glasoberflächen.

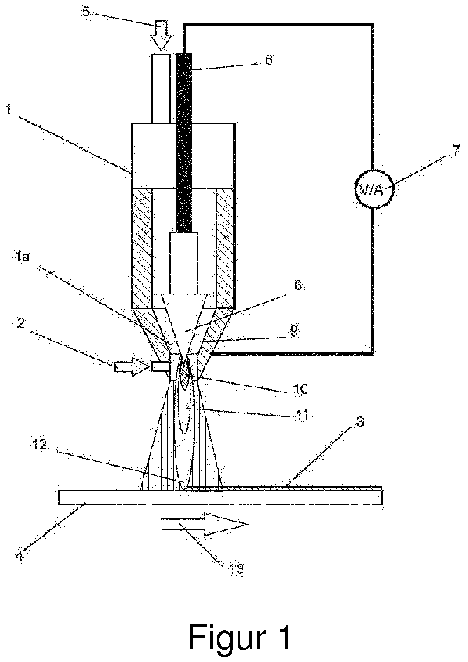

Figur 1 zeigt eine Vorrichtung zur Durchführung des Plasmabeschichtungsverfahrens umfassend eine Düse (1) mit einem auf ein Substrat (4) ausgerichteten Düsenkopf (1a). Der Düsenkopf (1a) läuft in Richtung einer Austrittsöffnung konisch zu. Im Inneren der Düse (1) ist eine längliche, sich in den Düsenkopf (1a) erstreckende Elektrode (8) angeordnet, die konzentrisch von einem Ringspalt (9) zwischen der Mantelfläche der Elektrode (8) und der Innenwand der Düse (1) umgeben wird. An der rückwärtigen, der Austrittsöffnung der Düse (1) gegenüberliegenden Stirnseite der Düse (1) befindet sich ein Einlass (5) für ein Inertgas, insbesondere Argon.

Eine Stromquelle (7) ist über einen Stromanschluss (6) elektrisch leitend mit der Elektrode (8) sowie dem Düsenkopf (1a) als Gegenelektrode verbunden. Die Stromquelle (7) erzeugt eine Lichtbogenentladung zwischen den Elektroden (8, 1a) in dem Ringspalt (9) mit einem Strom von mindestens 50 A und weniger als 100V. Der Abstand zwischen den Elektroden (8, 1a) beträgt maximal 10 mm. Das durch den Ringspalt (9) strömende Argon wird durch die Lichtbogenentladung angeregt und unter Atmosphärendruck ein Plasmastrahl erzeugt.

In Strömungsrichtung hinter der Spitze der Elektrode (8) ist im Düsenkopf (1a) eine Einspeisung (2) für ein metallorganisches Beschichtungsmaterial in den Plasmastrahl vorgesehen.

Das eingespeiste Beschichtungsmaterial gelangt von der Einspeisung (2), wie insbesondere aus Figur 1 erkennbar, in einen Bereich (10), dem Zuführbereich des Plasmastrahls, in dem eine Plasmatemperatur im Lichtbogen von 10.000 °C bis 50.000 °C herrscht. Hierdurch wird eine sehr hohe Energie zum Starten einer chemischen Reaktion in das eingespeiste Beschichtungsmaterial eingebracht. Andererseits wird eine kontrollierbare chemische Reaktion unter Ausschluss von Luftsauerstoff in dem Plasma aus Inertgas, insbesondere Argon, ermöglicht. Durch Einstellen des Abstandes zwischen dem Plasmakopf (1a) und der Oberfläche des Substrats (4), lässt sich die auf der Oberfläche wirksame Temperatur und die chemische Reaktion durch den in dem Randbereich des Plasmastrahls vorliegenden Luftsauerstoff der Umgebungsatmosphäre einstellen. Je größer der Abstand, desto mehr weitet sich der Kegel des Plasmastrahls aus, wodurch mehr Luftsauerstoff an der chemischen Reaktion beteiligt wird.

Aus Figur 1 ist weiter erkennbar, wie mit zunehmendem Abstand des Düsenkopfes (1a) zu dem Substrat (4) die Plasmatemperatur abnimmt. Der Plasmastrahl wird vorzugsweise derart erzeugt, dass die Plasmatemperatur etwa 50 mm in Austrittsrichtung hinter dem Düsenkopf, also in Figur 1 am Ende des Bereichs (11), weniger als 500 °C beträgt. In dem Bereich (12) beträgt die Temperatur des Plasmastrahls beim Auftreffen auf das Substrat weniger als 300° C.

Um eine gleichmäßige Abscheidung der Funktionsschicht (3), insbesondere einer Silikatschicht, auf der Oberfläche des Substrats (4) zu ermöglichen, weist die Vorrichtung Mittel zum Erzeugen einer Relativbewegung zwischen dem Substrat (4) und der Düse (1) auf. Im dargestellten Ausführungsbeispiel wird das Substrat (4) gleichmäßig in Richtung des Pfeils (13) unter der auf die Oberfläche des Substrats (4) ausgerichteten Düse (1) hindurchbewegt. Selbstverständlich ist es auch möglich, die Düse (1) über eine statische Oberfläche des Substrats zu bewegen oder sowohl die Düse als auch das Substrat relativ zueinander zu bewegen.

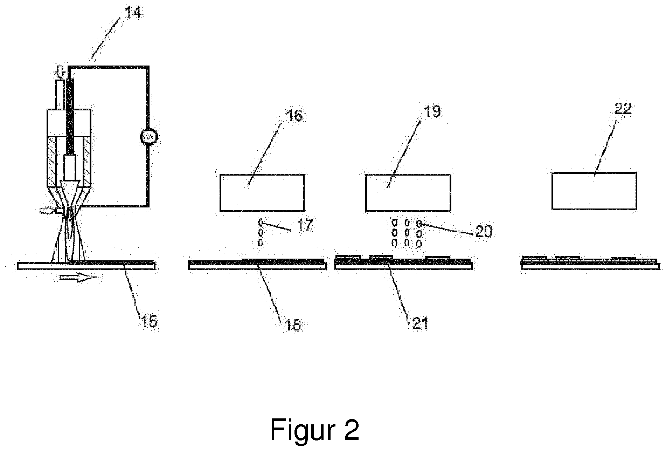

Figur 2 veranschaulicht ein zweistufiges Beschichtungsverfahren, wobei in einem ersten Schritt eine Silikatschicht (15) auf einem Substrat (4) mit einer Abscheidevorrichtung (14) entsprechend der Abscheidevorrichtung nach Figur 1 abgeschieden wird. Zur Vermeidung von Wiederholungen wird zum Aufbau und zur Arbeitsweise der Abscheidevorrichtung (14) vollumfänglich auf die Ausführungen zu Figur 1 verwiesen.

Nach dem Abscheiden der Silikatschicht (15) wird mittels eines Digital-Druckkopfes (16) eine Silanverbindung (17) auf der Oberfläche der Silikatschicht (15) abgeschieden. Die silanisierte Oberfläche (18) ist stark haftvermittelnd und wird in einem nächsten Verarbeitungsschritt mit einer UV-härtenden UV-Druckfarbe (20) mit Hilfe eines weiteren Digital-Druckkopfes (19) bedruckt. Auf dem Substrat, beispielsweise Glas, entsteht hierdurch ein Druckbild (21). Um die aufgebrachte UV-Druckfarbe rasch auszuhärten, kann das bedruckte Substrat (4) einer Härtungseinrichtung (22) zur Härtung der UV-Druckfarbe (20) zugeführt werden.

**Bezugszeichenliste**

| **Nr.** | **Bezeichnung** |
|---|---|
| 1 | Düse |
| 1a | Düsenkopf |
| 2 | Einspeisung Beschichtungsmaterial (Precursor) |
| 3 | Funktionsschicht (Silikatschicht) |
| 4 | Substrat |
| 5 | Einlass Trägergas (Argon) |
| 6 | Stromanschluss |
| 7 | Stromquelle |
| 8 | Elektrode |
| 9 | Ringspalt |
| 10 | Bereich der höchsten Plasmatemperatur >10.000°C |
| 11 | Bereich mit einer Plasmatemperatur <500°C |
| 12 | Bereich mit einer Plasmatemperatur <300°C |
| 13 | Bewegungsrichtung |
| 14 | Abscheidevorrichtung |
| 15 | Silikatschicht |
| 16 | Digital-Druckkopf |
| 17 | Silanverbindung |
| 18 | Silanisierte Oberfläche |
| 19 | Digital-Druckkopf |
| 20 | UV-Druckfarbe |
| 21 | Druckbild |
| 22 | Härtungseinrichtung |

## Patentansprüche

1. Plasmabeschichtungsverfahren zum Abscheiden einer Funktionsschicht (3) auf einer Oberfläche eines Substrats (4) umfassend die Schritte:
- Bereitstellen von Inertgas als Trägergas für das Plasmabeschichtungsverfahren,
- Erzeugen eines Plasmastrahls unter Atmosphärendruck durch Anregen des durch eine Düse (1) mit einem Düsenkopf (1a) strömenden Inertgases, wobei die Anregung des Inertgases durch eine Lichtbogenentladung zwischen zwei im Abstand zueinander angeordneten Elektroden (8, 1a) erfolgt, die mit einer Stromquelle (7) verbunden sind und der Strom zur Erzeugung der Lichtbogenentladung zwischen 10 A - 300 A und die Spannung zur Erzeugung der Lichtbogenentladung zwischen 10 V - 100 V beträgt,
- Einbringen mindestens eines Beschichtungsmaterials in den Plasmastrahl, wobei in dem Plasma eine kontrollierbare chemische Reaktion unter Ausschluss von Luftsauerstoff bis zu dessen Austritt aus dem Düsenkopf (1a) erfolgt und
- Ausrichten des aus dem Düsenkopf (1a) austretenden Atmosphärendruckplasmas auf die Oberfläche des Substrats (4).

2. Plasmabeschichtungsverfahren nach Anspruch 1, **dadurch gekennzeichnet, dass** als Inertgas ein Edelgas verwendet wird.

3. Plasmabeschichtungsverfahren nach Anspruch 2, **dadurch gekennzeichnet, dass** als Inertgas Argon verwendet wird.

4. Plasmabeschichtungsverfahren nach Anspruch 2, **dadurch gekennzeichnet, dass** als Inertgas Argon mit einer Reinheit von mindestens 4.6 verwendet wird.

5. Plasmabeschichtungsverfahren nach einem der Ansprüche 1 bis 4, **dadurch gekennzeichnet, dass** der Plasmastrahl mit folgenden Parametern erzeugt wird:
- der Abstand zwischen den Elektroden (8, 1a) beträgt maximal 10 mm und
- der der Düse (1) zugeführte Inertgasstrom beträgt zwischen 5-50 1/min.

6. Plasmabeschichtungsverfahren nach einem der Ansprüche 1 bis 5, **dadurch gekennzeichnet, dass** der Plasmastrahl mit folgenden Parametern erzeugt wird:
- der Abstand zwischen den Elektroden (8, 1a) ist kleiner als 5 mm und /oder
- der Strom zur Erzeugung der Lichtbogenentladung beträgt mindestens 50 A.

7. Plasmabeschichtungsverfahren nach Anspruch 5 oder 6, **dadurch gekennzeichnet, dass** der Abstand zwischen den Elektroden, der Strom und die Spannung zur Erzeugung der Lichtbogenentladung und der der Düse zugeführte Inertgasstrom derart bestimmt werden, dass
- die Plasmatemperatur im Lichtbogen (10) 10.000°C-50.000°C und/oder
- die Plasmatemperatur 50 mm in Austrittsrichtung (11) hinter dem Düsenkopf (1a) weniger als 500°C beträgt.

8. Plasmabeschichtungsverfahren nach einem der Ansprüche 1 bis 7, **dadurch gekennzeichnet, dass** das mindestens eine Beschichtungsmaterial gasförmig in den Plasmastrahl eingebracht wird.

9. Plasmabeschichtungsverfahren nach einem der Ansprüche 1 bis 8, **dadurch gekennzeichnet, dass** das mindestens eine Beschichtungsmaterial gasförmig in den Plasmastrahl in einem Zuführbereich eingebracht wird, wobei der Zuführbereich in einem Bereich des Plasmastrahls mit einer Temperatur angeordnet ist, die ein teilweises thermisches Aufbrechen der molekularen Bindungen des Beschichtungsmaterials derart bewirkt, dass die freien Radikale neue Bindungen zu Molekülen der Substratoberfläche und den übrigen teilweise aufgebrochenen Molekülen suchen.

10. Plasmabeschichtungsverfahren nach einem der Ansprüche 1 bis 9, **dadurch gekennzeichnet, dass** mindestens ein metallorganisches Beschichtungsmaterial in den Plasmastrahl eingebracht wird.

11. Plasmabeschichtungsverfahren nach einem der Ansprüche 1 bis 10, **dadurch gekennzeichnet, dass** ein Beschichtungsmaterial aus der nachfolgenden Gruppe in den Plasmastrahl eingebracht wird:
SiO₂, WOₓ, MoOₓ, ZnO, ZrO₂, SnO₂, TiO₂, Ag, Al₂O₃.

12. Plasmabeschichtungsverfahren nach einem der Ansprüche 1 bis 11, **dadurch gekennzeichnet, dass** nach dem Abscheiden einer als Silikatschicht (3,15) ausgebildeten Funktionsschicht eine Silanisierung der Oberfläche erfolgt.

13. Plasmabeschichtungsverfahren nach Anspruch 12, **dadurch gekennzeichnet, dass** eine Silanverbindung (17) mittels eines Druckkopfes (16) auf die Silikatschicht (3,15) aufgebracht wird.

14. Plasmabeschichtungsverfahren nach einem der Ansprüche 1 bis 13, **dadurch gekennzeichnet, dass** das Substrat (4) während der Beschichtung relativ zu der Düse (1) bewegt wird.

15. Vorrichtung zur Durchführung des Verfahrens nach einem oder mehreren der Ansprüche 1 bis 14, **gekennzeichnet durch**,
- eine Inertgasversorgung,
- eine Düse (1) mit einem auf ein Substrat (4) ausgerichteten Düsenkopf (1a) geeignet zum Erzeugen eines Plasmastrahls unter Atmosphärendruck,
- in der Düse (1) angeordnete Elektroden (8, 1a) zum Anregen des durch die Düse (1) strömenden Inertgases durch eine Lichtbogenentladung,
- eine Stromquelle (7), die elektrisch leitend mit den Elektroden (8, 1a) verbunden und geeignet ist, die Lichtbogenentladung zwischen den Elektroden (8, 1a) mit einem Strom zwischen 10 A - 300 A und einer Spannung zwischen 10 - 100 V zu erzeugen,
- eine im Bereich des Düsenkopfes (1a) angebrachte Einspeisung (2) zum Einbringen eines metallorganischen Beschichtungsmaterials in den Plasmastrahl sowie
- Mittel zum Erzeugen einer Relativbewegung (13) zwischen dem Substrat (4) und der Düse (1).

16. Vorrichtung nach Anspruch 15, **gekennzeichnet durch**, dass die Inertgasversorgung zum Bereitstellen von Argon mit einer Reinheit von mindestens 4.6 eingerichtet ist.

17. Vorrichtung nach Anspruch 15 oder 16, **dadurch gekennzeichnet, dass** die Inertgasversorgung zum Bereitstellen eines Inertgasstroms mit einem Volumenstrom zwischen 5 - 50 l/min eingerichtet ist.

18. Vorrichtung nach Anspruch 15 oder 16, **dadurch gekennzeichnet, dass** der Abstand zwischen den in der Düse (1) angeordnete Elektroden (8, 1a) maximal 10 mm beträgt.

19. Vorrichtung nach einem der Ansprüche 15 bis 18, **dadurch gekennzeichnet, dass** die Stromquelle (7) geeignet ist, die Lichtbogenentladung zwischen den Elektroden (8, 1a) mit einem Strom von mindestens 50 A zu erzeugen.

20. Vorrichtung nach einem der Ansprüche 15 bis 19, **gekennzeichnet durch** einen Druckkopf (16) geeignet zum Aufbringen einer Silanverbindung (17) auf eine zuvor abgeschiedene Silikatschicht (3, 15).

21. Vorrichtung nach Anspruch 20 **gekennzeichnet durch** einen weiteren Druckkopf (19) geeignet zum Aufbringen einer weiteren Schicht (20) auf die silanisierte Oberfläche (18).

22. Vorrichtung nach einem der Ansprüche 15 bis 21 **gekennzeichnet durch** eine Härtungseinrichtung (22) zum Aushärten der abgeschiedenen Schichten (21) .

## Claims

1. Plasma coating method for depositing a functional layer (3) on a surface of a substrate (4) comprising the steps:
- providing inert gas as carrier gas for the plasma coating method,
- producing a plasma jet at atmospheric pressure by exciting the inert gas flowing through a nozzle (1) with a nozzle head (1a), wherein the excitation of the inert gas is accomplished by an arc discharge between two electrodes (8, 1a) arranged at a distance from one another, which are connected to a current source (7), and the current for generating the arc discharge is between 10 A - 300 A and the voltage for producing the arc discharge is between 10 V - 100 V,
- introducing at least one coating material into the plasma jet, wherein a controllable chemical reaction takes place in the plasma with the exclusion of air oxygen until its exit from the nozzle head (1a) and
- aligning the atmospheric pressure plasma exiting from the nozzle head (1a) onto the surface of the substrate (4).

2. The plasma coating method according to claim 1, **characterized in that** a noble gas is used as inert gas.

3. The plasma coating method according to claim 2, **characterized in that** argon is used as inert gas.

4. The plasma coating method according to claim 2, **characterized in that** argon having a purity of at least 4.6 is used as inert gas.

5. The plasma coating method according to any one of claims 1 to 4, **characterized in that** the plasma jet having the following parameters is produced:
- the distance between the electrodes (8, 1a) is a maximum of 10 mm and
- the inert gas stream supplied to the nozzle (1) is between 5-50 1/min.

6. The plasma coating method according to any one of claims 1 to 5, **characterized in that** the plasma jet having the following parameters is produced:
- the distance between the electrodes (8, 1a) is less than 5 mm and/or
- the current for generating the arc discharge is at least 50 A.

7. The plasma coating method according to claim 5 or 6, **characterized in that** the distance between the electrodes, the current and the voltage for generating the arc discharge and the inert gas stream supplied to the nozzle are determined in such a manner that
- the plasma temperature in the arc (10) is 10, 000°C-50, 000°C and/or
- the plasma temperature 50 mm in the outlet direction (11) downstream of the nozzle head (1a) is less than 500°C.

8. The plasma coating method according to any one of claims 1 to 7, **characterized in that** the at least one coating material is introduced into the plasma jet in gaseous form.

9. The plasma coating method according to any one of claims 1 to 8, **characterized in that** the at least one coating material is introduced into the plasma jet in gaseous form in a supply zone, wherein the supply zone is located in a region of the plasma jet having a temperature which causes a partial thermal breaking of the molecular bonds of the coating material in such a manner that the free radicals seek new bonds to molecules of the substrate surface and the remaining partially broken molecules.

10. The plasma coating method according to any one of claims 1 to 9, **characterized in that** at least one metallorganic coating material is introduced into the plasma jet.

11. The plasma coating method according to any one of claims 1 to 10, **characterized in that** a coating material from the following group is introduced into the plasma jet:
SiO₂, WOₓ, MoOₓ, ZnO, ZrO₂, SnO₂, TiO₂, Ag, Al₂O₃.

12. The plasma coating method according to any one of claims 1 to 11, **characterized in that** after deposition of a functional layer formed as a silicate layer (3, 15), a silanization of the surface takes place.

13. The plasma coating method according to claim 12, **characterized in that** a silane compound (17) is applied by means of a printing head (16) to the silicate layer (3, 15).

14. The plasma coating method according to any one of claims 1 to 13, **characterized in that** the substrate (4) is moved relative to the nozzle (1) during the coating.

15. Apparatus for carrying out the method according to one or more of claims 1 to 14, **characterized by**
- an inert gas supply,
- a nozzle (1) with a nozzle head (1a) aligned onto a substrate (4) suitable for producing a plasma jet at atmospheric pressure,
- electrodes (8, 1a) arranged in the nozzle (1) for exciting the inert gas flowing through the nozzle (1) by an arc discharge,
- a current source (7) which is connected in an electrically conducting manner to the electrodes (8, 1a) and which is suitable to produce the arc discharge between the electrodes (8, 1a) with a current between 10 A - 300 A and a voltage between 10 - 100 V,
- a feed (2) attached in the region of the nozzle head (1a) for introducing a metallorganic coating material into the plasma jet and
- means for producing a relative movement (13) between the substrate (4) and the nozzle (1).

16. The apparatus according to claim 15, **characterized in that** the inert gas supply is adapted for providing argon with a purity of at least 4.6.

17. The apparatus according to claim 15 or 16, **characterized in that** the inert gas supply is adapted for providing an inert gas stream with a volume flow between 5-50 1/min.

18. The apparatus according to claim 15 or 16, **characterized in that** the distance between the electrodes (8, 1a) arranged in the nozzle (1) is a maximum of 10 mm.

19. The apparatus according to any one of claims 15 to 18, **characterized in that** the current source (7) is suitable for producing the arc discharge between the electrodes (8, 1a) with a current of at least 50 A.

20. The apparatus according to any one of claims 15 to 19, **characterized by** a printing head (16) suitable for applying a silane compound (17) to a previously deposited silicate layer (3, 15).

21. The apparatus according to claim 20, **characterized by** another printing head (19) suitable for applying another layer (20) to the silanized surface (18).

22. The apparatus according to any one of claims 15 to 21, **characterized by** a curing device (22) for curing the deposited layers (21).

## Revendications

1. Procédé de revêtement par plasma pour déposer une couche fonctionnelle (3) sur une surface d'un substrat (4), comprenant les étapes suivantes :
- la mise à disposition de gaz inerte en tant que gaz porteur pour le procédé de revêtement par plasma,
- la génération d'un jet de plasma sous pression atmosphérique par excitation du gaz inerte circulant à travers une buse (1) avec une tête de buse (la), dans lequel l'excitation du gaz inerte s'effectue par une décharge en arc électrique entre deux électrodes (8, 1a) disposées à distance l'une de l'autre, lesquelles sont reliées à une source de courant (7) et le courant pour la génération de la décharge en arc électrique comportant de 10 A - 300 A et la tension pour la génération de la décharge en arc électrique comportant entre 10 V - 100 V,
- l'introduction d'au moins un matériau de revêtement dans le jet de plasma, dans lequel, dans le plasma, une réaction chimique contrôlable a lieu en l'absence d'oxygène de l'air jusqu'à la sortie de celui-ci de la tête de buse (1a) et
- la direction du plasma à pression atmosphérique sortant de la tête de buse (1a) sur la surface du substrat (4).

2. Procédé de revêtement par plasma selon la revendication 1, **caractérisé en ce que** l'on utilise du gaz noble en tant que gaz inerte.

3. Procédé de revêtement par plasma selon la revendication 2, **caractérisé en ce que** l'on utilise de l'argon en tant que gaz inerte.

4. Procédé de revêtement par plasma selon la revendication 2, **caractérisé en ce que** l'on utilise, en guise de gaz inerte, de l'argon avec une pureté d'au moins 4.6.

5. Procédé de revêtement par plasma selon l'une des revendications 1 à 4, **caractérisé en ce que** le jet de plasma est généré avec les paramètres suivants :
- la distance entre les électrodes (8, 1a) comporte 10 mm au maximum et
- le flux de gaz inerte amené vers la buse (1) comporte entre 5-50 1/min.

6. Procédé de revêtement par plasma selon l'une des revendications 1 à 5, **caractérisé en ce que** le jet de plasma est généré avec les paramètres suivantes :
- la distance entre les électrodes (8, 1a) est inférieure à 5 mm et/ou
- le courant pour la génération de la décharge en arc électrique comporte au moins 50 A.

7. Procédé de revêtement par plasma selon la revendication 5 ou 6, **caractérisé en ce que** la distance entre les électrodes, le courant et la tension pour la génération de la décharge en arc électrique et le flux de gaz inerte amené à la buse sont déterminés de manière à ce que
- la température du plasma dans l'arc électrique (10) comporte 10 000°C - 50 000°C et/ou
- la température du plasma 50 mm en direction de sortie (11) derrière la tête de buse (1a) comporte moins de 500°C.

8. Procédé de revêtement par plasma selon l'une des revendications 1 à 7, **caractérisé en ce que** l'au moins un matériau de revêtement est introduit sous forme gazeuse dans le jet de plasma.

9. Procédé de revêtement par plasma selon l'une des revendications 1 à 8, **caractérisé en ce que** l'au moins un matériau de revêtement est introduit sous forme gazeuse dans le jet de plasma dans une zone d'amenée, dans lequel la zone d'amenée est disposée dans une zone du jet de plasma avec une température qui a pour effet une rupture thermique partielle des liaisons moléculaires du matériau de revêtement de manière à ce que les radicaux libres recherchent de nouvelles liaisons avec des molécules de la surface de substrat et les autres molécules partiellement rompues.

10. Procédé de revêtement par plasma selon l'une des revendications 1 à 9, **caractérisé en ce qu'**au moins un matériau de revêtement organométallique est introduit dans le jet de plasma.

11. Procédé de revêtement par plasma selon l'une des revendications 1 à 10, **caractérisé en ce qu'**un matériau de revêtement du groupe suivant est introduit dans le jet de plasma :
SiO₂, WOₓ, MoOₓ, ZnO, ZrO₂, SnO₂, TiO₂, Ag, Al₂O₃.

12. Procédé de revêtement par plasma selon l'une des revendications 1 à 11, **caractérisé en ce qu'**après le dépôt d'une couche fonctionnelle réalisée en tant que couche de silicate (3, 15), il y a une silanisation de la surface.

13. Procédé de revêtement par plasma selon la revendication 12, **caractérisé en ce qu'**un composé de silane (17) est appliqué au moyen d'une tête d'impression (16) sur la couche de silicate (3, 15).

14. Procédé de revêtement par plasma selon l'une des revendications 1 à 13, **caractérisé en ce que** le substrat (4) est déplacé par rapport à la buse (1) pendant le revêtement.

15. Dispositif pour la mise en oeuvre du procédé selon l'une ou plusieurs des revendications 1 à 14, **caractérisé par**
- une alimentation en gaz inerte,
- une buse (1) avec une tête de buse (1a) dirigée sur un substrat (4) adaptée pour la génération d'un jet de plasma sous pression atmosphérique,
- des électrodes (8, 1a) disposées dans la buse (1) pour l'excitation du gaz inerte circulant à travers la buse (1) par une décharge en arc électrique,
- une source de courant (7) reliée , de manière électroconductrice aux électrodes (8, 1a) et qui convient pour générer la décharge en arc électrique entre les électrodes (8, 1a) avec un courant entre 10 A - 300 A et une tension entre 10 - 100 V,
- une alimentation (2) aménagée dans la zone de la tête de buse (1a) pour l'introduction d'un matériau de revêtement organométallique dans le jet de plasma ainsi que
- des moyens pour la génération d'un mouvement relatif (13) entre le substrat (4) et la buse (1).

16. Dispositif selon la revendication 15, **caractérisé en ce que** l'alimentation en gaz inerte est étudiée pour la mise à disposition d'argon avec une pureté d'au moins 4.6.

17. Dispositif selon la, revendication 15 ou 16, **caractérisé en ce que** l'alimentation en gaz inerte est étudiée pour la mise à disposition d'un flux de gaz inerte avec un débit compris entre 5 - 50 1/min.

18. Dispositif selon la revendication 15 ou 16, **caractérisé en ce que** la distance entre les électrodes (8, 1a) disposées dans la buse (1) comporte 10 mm au maximum.

19. Dispositif selon l'une des revendications 15 à 18, **caractérisé en ce que** la source de courant (7) convient pour générer la décharge en arc électrique entre les électrodes (8, 1a) avec un courant d'au moins 50 A.

20. Dispositif selon l'une des revendications 15 à 19, **caractérisé par** une tête d'impression (16) adaptée pour l'application d'un composé de silane (17) sur une couche de silicate (3, 15) préalablement déposée.

21. Dispositif selon la revendication 20, **caractérisé par** une autre tête d'impression (19) adaptée pour l'application d'une autre couche (20) sur la surface silanisée (18).

22. Dispositif selon l'une des revendications 15 à 21, **caractérisé par** un dispositif de durcissement (22) pour faire durcir les couches déposées (21).
